# EUROPEAN PATENT SPECIFICATION

(11) **EP 0 917 544 B1**
(45) Date of publication and mention of the grant of the patent: **18.12.2002**
(21) Application number: 97910760.4
(22) Date of filing: 29.09.1997
(51) Int. Cl.: C08F 8/12, C09D 129/04, C09D 131/02, G03F 7/09

(54) **WATER SOLUBLE AND OXYGEN-IMPERMEABLE POLYMERIC LAYERS**
WASSERLÖSLICHE, SAUERSTOFFUNDURCHLÄSSIGE POLYMERSCHICHTEN
COUCHES POLYMERES IMPERMEABLES A L'OXYGENE ET HYDROSOLUBLES

(30) Priority: 27.09.1996 DE 19639897
(43) Date of publication of application: 26.05.1999
(73) Proprietor: Kodak Polychrome Graphics LLC, Norwalk, Connecticut 06851 (US)
(72) Inventor: BAUMANN, Harald, D-37520 Osterode (DE); DWARS, Udo, D-37412 Herzberg (DE); SAVARIAR-HAUCK, Celin, M., D-37534 Badenhausen (DE); PAPPAS, Socrates, Peter, Wood-Ridge, NJ 07075 (US); TIMPE, Hans-Joachim, D-37520 Osterode (DE)
(74) Representative: VOSSIUS & PARTNER
(86) International application number: US9717761
(87) International publication number: WO98013394

(56) References cited:
- EP-A- 0 339 371
- EP-A- 0 627 656
- EP-A- 0 632 096
- EP-A- 0 752 430
- EP-A- 0 752 622
- EP-A- 0 757 061
- DE-A- 4 034 543
- DE-A- 4 325 015
- DE-A- 19 516 435
- US-A- 2 748 103
- PATENT ABSTRACTS OF JAPAN vol. 004, no. 038 (C-004), 27 March 1980 & JP 55 012171 A (SEKISUI CHEM CO LTD), 28 January 1980,
- PATENT ABSTRACTS OF JAPAN vol. 004, no. 050 (C-007), 16 April 1980 & JP 55 023163 A (AGENCY OF IND SCIENCE & TECHNOL), 19 February 1980,
- PATENT ABSTRACTS OF JAPAN vol. 011, no. 048 (M-561), 13 February 1987 & JP 61 211081 A (KURARAY CO LTD), 19 September 1986,
- PATENT ABSTRACTS OF JAPAN vol. 097, no. 003, 31 March 1997 & JP 08 310123 A (FUJI PHOTO FILM CO LTD), 26 November 1996,

## Description

The invention relates to light-sensitive systems comprising a photosensitive layer and a water soluble and oxygen impermeable polymeric overcoat.

Water soluble polymers are used as temporary coatings on organic photosensitive substrates. They are also used, for example, in manufacturing offset printing molds, letterpress plates, litho plates for screen printing, printed boards and in etching preforms.

In the uses stated above the water soluble polymers have the function of protecting the substrate from aerial oxygen during storage, exposure and particularly during the period between exposure and further processing (development). During this period the temporary coating has to exhibit a sufficient adhesion to the photosensitive substrate so that a safe handling (manufacture, packing, transport, exposure) is guaranteed such that the layers are not torn. On the other hand it must easily be possible to remove the temporary coating before development, at best by washing with water.

A plurality of water soluble polymers were tested in practice. It was found that polymers such as polyvinyl alcohol, partly saponified polyvinyl acetate, which can also contain vinyl ether and vinyl acetal units, polyvinyl pyrrolidone and copolymers thereof with vinyl acetate and vinyl ethers, hydroxy alkyl cellulose, gelatin, polyacrylic acid, gum arabic, polyacrylic amide, dextrin, copolymers of alkyl vinyl ethers and maleic acid anhydride as well as water soluble high molecular polymers of ethylene oxide having a molecular weight of above 5000 are particularly suitable. This is due to the low oxygen permeability of these polymers, compare measured values in K. Petrak, E. Pitts, J. Appl. Polym. Sci. 25 (5) pages 8789 - 886. Polyvinyl alcohol is particularly suitable. However, many of the polymers prove to be insufficient in their adherence to organic, photosensitive, substrates. For example, polyvinyl alcohol layers can easily be removed by means of adhesive tapes or by cutting substrates coated with polyvinyl alcohols, the water soluble protective coating often peels off easily at the edge the cut.

Furthermore it was found that some water soluble polymers used as coatings affect specific properties of the photosensitive layers such as include photosensitivity, resolving capacity and thermal stability in storage. A number of tests have been carried out to improve the properties of the water soluble protective layers on organic photosensitive substrates.

U.S. Patent 3,458,311 describes coating a water soluble overcoat in the presence of a solvent mixable with water for the provision of adherence. However, the adhesion capacity is only improved to a minor extent because of the high solvent content. Thus, the components of the photosensitive layer are easily removed, which impairs the function of this layer considerably.

U.S. Patents 4, 072, 527 and 4, 072, 528 disclose polymer coatings dissolved in water having insoluble polymers dispersed therein. However, the removability of the resulting coatings by aqueous media is reduced along with the shelf life of the materials.

U.S. Patent 4,942,111 describes amphoteric compound additives to water soluble coatings. However, the adhesion of the coatings is too low.

U.S. Patent 4,988,607 describes coatings which contain a maximum of 20 wt.% of photoinitiators. However, only water soluble initiators can be introduced into the coating. Furthermore, the adherence and thermal stability of the system is not improved.

The situation is similar when antihalation dyes are introduced into the coating according to European Patent 354 475 or polymerization inhibitors according to U.S. Patent 5,254,437. Slightly improved sharpness of the photosensitive layer is obtained while photosensitivity is reduced and the poor adhesion of the coatings remains.

U.S. Patent 5,273,862 discloses the combination of a water soluble polymer having a low aerial oxygen permeability with an aerial-oxygen-binding water soluble polymer. Polymers with aliphatic amino groups, preferably polyalkylene imines, are mentioned as aerial-oxygen-binding polymers. However, such combinations prove to be unsuitable for the practical use, because amino-group containing polymers exhibit a high tendency to absorption at the surface of the photopolymer. Therefore the photopolymer surface remains hydrophilic, even after the development, which results in poor ink receptivity on plates made with these polymers.

An object of the present invention is to provide water soluble oxygen-impermeable coatings which, when used in photosensitive lithographic printing plates, not only result in a high photosensitivity (independent of the outside air pressure), good resolution, good ink receptivity after the development, but above all, guarantee long shelf life of the lithographic plate and good adhesion to the organic substrate.

The invention is a light-sensitive system comprising a photosensitive layer consisting of photoinitiators which absorb within the range of from 300 to 800 nm, free radical polymerizable components, and optionally alkali soluble binders and/or additives, and a water-soluble overcoat, wherein the overcoat comprises a polymer consisting of the following units: 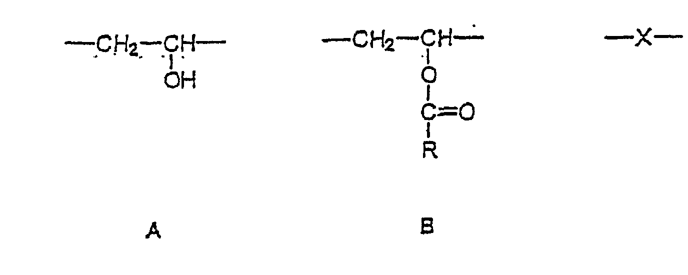 wherein R is a C₁-C₈ straight-chain or a branched alkyl and the X comprises an amino group that is connected to the polymer chain either directly or via a spacer. Preferably unit X is at least one of two structures below: 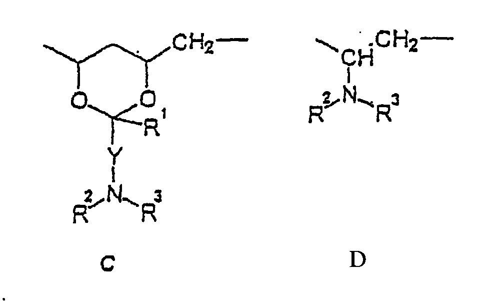 wherein R¹, R² and R³ are independently selected from hydrogen, alkyl, aralkyl or aryl and Y is an aliphatic, aromatic or araliphatic spacer group.

The light sensitive systems according to the invention, comprise an overcoat which exclusively consist of the polymer according to the invention, exhibit a low oxygen permeability even if the layers are very thin. This property is particularly due to the amount of binder units A and B described above.

The particular advantage of the coatings according to the invention is their extremely good adhesion to organic substrates. This adhesion is especially strong when the organic substrates contain polar groups such as carboxyl groups. This adhesion is obtained above all by the basic, nitrogen-containing binder units X in the polymer according to the invention.

The basic amino groups are especially suitable due to their provision of adhesion. The amino groups may be primary, secondary or also tertiary.

By means of varying the amount of the basic, nitrogen-containing groups in the water soluble polymer, the adhesion capacity can be adapted according to the corresponding adhesion problem in practice. It is proven that the water soluble coatings according to the invention contain polymers consisting of 10 to 98 wt.% of binder unit A, 0.1 to 30 wt.% of binder unit B and 0.1 to 60 wt.% of X.

Polymers, according to the invention, suitable as a binder in coatings may contain other compounds such as rheological additives, foam separators, dyeing agents, stabilizers and/or preservatives, but also other polymers or copolymers such as polyvinyl alcohol, gelatin or hydroxy alkyl cellulose, and other polymers known to one skilled in the art as oxygen-impermeable compositions.

There are basically two different ways to introduce the basic nitrogen-containing binder unit X into the polymers of the water soluble coatings of the invention. Namely, (a) the copolymerization with nitrogen-containing monomers and optionally further reactions with the polymer and (b) the reaction of polymers with nitrogen-containing low molecular compounds.

In preparing the pollymers of the water soluble coatings of the invention by copolymerization, generally a vinyl ester is copolymerized with the nitrogen-containing monomers; subsequently the ester groups are saponified to the desired extent by acid or alkaline saponification, then the product is isolated. The polymerization, saponification and isolation steps are carried out according to processes well-known to those of ordinary skill in the art. A particularly preferred process is where vinyl acetate which is free radical polymerized with the nitrogen-containing monomers.

Frequently, it is preferable to start with nitrogen-containing monomers in which the amino groups are present in a protected form, so that no undesirable side reactions take place during the polymerization step. A preferred way of protecting the amino groups is by acylation. Especially preferred is acylation with a formyl or acetyl group. The protective groups of this type are particularly advantageous since they are removed in the saponification step of, for example, a vinyl acetate group.

The free radical copolymerization of vinyl acetate with N-vinyl acetamide or N-vinyl formamide and their saponification, resulting in a polymer consisting of vinyl alcohol, vinyl acetate and vinyl amine, proved to be especially suitable and economical.

The second method for making the polymers coatings under the invention involves, commercially available, almost completely or partly saponified, polyvinyl ester, simply referred to as "polyvinyl alcohol". It is modified by a reaction-analogous to a polymer reaction. This is an especially suitable way to form the binder unit embodied by structure C of amino group containing aldehydes or their acetals. The polyvinyl alcohols preferably used for synthesis in the present invention have a residual content of esterified groups in the range of between 0.1 to 30 wt.%. Especially preferred are polyvinyl alcohols prepared from polyvinyl acetate, i.e. R = CH₃ in binder unit B, having a residual acetate content of between 1.5 to 22 wt.%. The adhesion capacity as well as the water solubility of the coatings according to the invention is influenced by the molecular weight of the polyvinyl alcohols used for the synthesis. A lower molecular weight promotes the removal of the coating by water, or in the case of lithographic plates by means of aqueous alkaline developers. The use of polyvinyl alcohols exhibit viscosities of between 2 and 26 mPa·s as 4% aqueous solution in water at 20°C.

The amino group containing aldehydes or acetals of amino group containing aldehydes are reacted with polyvinyl alcohols according to standard processes known per se forming acetal structures (corresponding to structure C). Examples of amino group containing aldehydes or acetals of amino group containing aldehydes are: 2-amino acetaldehyde dimethyl acetal, 2-amino acetaldehyde diethyl acetal, 2-N-methyl amino acetaldehyde diethyl acetal, 2-N-methyl amino acetaldehyde dimethyl acetal, 4-amino butyraldehyde dimethyl acetal, 4-amino butyraldehyde diethyl acetal, 2-amino propionaldehyde dimethyl acetal, 2-amino propionaldehyde diethyl acetal, 4-N,N-dimethyl amino benzaldehyde and 4-N,N-diethyl amino benzaldehyde.

This reaction generally requires the addition of a strong inorganic or organic catalytic acid. Examples of catalytic acids include hydrochloric acid, sulfuric acid, phosphoric acid and p-toluene sulfuric acid. An especially preferred catalytic acid is hydrochloric acid. The amount of the acid added preferably ranges from 1 to 25 wt.% depending on the amount of polyvinyl alcohol used.

The reaction temperature of the acetalization depends on the type of aldehydes employed as well as the desired degree of reaction. The reaction temperature is preferably between 0°C and the boiling point of the solvent used. More preferably, the reaction temperature ranges between 5°C and 100°C.

Water and organic solvents as well as mixtures of water with organic solvents are used as acetalizing solvents. Particularly suitable acetalizing organic solvents are alcohols (such as methanol, ethanol, propanol, butanol or glycolether), cyclic ethers (such as tetrahydrofuran, 1,4-trioxane, 1,3-dioxolane) or dipolar aprotic solvents (such as dimethylsulfoxide, formamide, N,N-dimethylformamide, hexamethyl phosphoric acid triamide or N-methylpyrrolidone).

If the acetalization is carried out in organic solvents or mixtures of organic solvents with water, often the reaction product will remain in the solvent, even if the starting polyvinyl alcohol was not dissolved completely. This has the advantage that the degree of reaction can quite easily be reproduced. In order to isolate the finished product as a solid, the polymer solution is introduced into a non-solvent for the polymer under stirring, filtered off and dried. As a non-solvent for the polymer e.g. acetone or methyl ethyl ketone is especially suitable.

Another method, which is also practicable, is to add the non-solvent for the polymer to the synthesized solution under stirring. Before the polymer is isolated as a solid, it is suitable to neutralize the catalytic acid in an appropriate step at least partially, since the free base of the amino group containing polymers has the best adhesive effect in the water soluble coating. This can be carried out for instance by adding solid or dissolved organic or inorganic bases to the reaction preparation.

If the acetalization is carried out in water, for some uses, the complicated isolation by precipitation can be dispensed with and an aqueous synthesized solution can be used. Here, too, at least partial neutralization of the catalytic acid is achieved by adding solid or dissolved organic or inorganic bases to the reaction and this has a positive effect on suitable properties regarding the technical application.

The application of the water soluble coatings of the present invention is carried out according to processes of surface coating well-known to those of ordinary skill in the art such as doctor blade coating, roller coating, slot coating, curtain coating, injection or dipping method. Depending on the respective process employed, the basis weight per area of coating will range from 0.05 to 10 g/m².

In many cases it is suitable to apply a water soluble coating made of an aqueous solution. This has the least negative effects on the environment and on humans. For specific uses, however, it can also be suitable to use organic solvents. In some substrates the addition of from 0.5 to 60 wt.% of an organic solvent to the aqueous coating solution improves the adhesion capacity. By means of a minor solvation of the composition surface, the adhesive effect of the polymers of the coatings according to the present invention is increased further. Such additives to solvents can be, for example, alcohols or ketones.

For a proportional and quick wetting of the substrate surface, anionic, cationic or non-ionic wetting agents may be added to the coating solutions. The type and quantity are to be determined on the basis of the recommendations made by the manufacturer of such wetting agents by means of suitable tests. The quality appearance of the surface ("surface cosmetics") can furthermore be influenced by adding rheological additives such as flow improvers or thickeners such as hydroxy methyl cellulose, gelatin, polyvinyl alcohol, gum arabic or polyvinyl pyrrolidone.
In order to compensate for disturbing foam formation that results from certain components of the coating solution of the invention and turbulences, as well as air in the' coating process, foam separating substances such as silicone containing compounds are optionally added to the coating solutions. For some uses it is also suitable to add dyes to the water soluble coating solutions for optical reasons regarding the finished product and the assessment of faults in the coating. It can also have functional reasons such as the improvement of the picture quality in photostructuring processes. The dyes may be added in a dissolved or finely dispersed form.

For specific uses the water soluble coatings can contain up to 30 wt.% of particles within the range of 0.05 to 50 µm, preferably 0.5 to 20µm. This way specific optical effects such as mattness, increased mechanical strength and an improved contact with typons in vacuum printing frames when used for lithographic plates. Such particles can consist of organic substances, preferably polymers, inorganic materials such as silicon dioxide, aluminium oxide or inorganic substances modified organically at the surface.

According to one embodiment of the present invention the water-soluble overcoat additionally comprises at least one other polymer consisting of vinyl alcohol and vinyl acetate groups and/or at least one additive selected from a wetting agent, a solid having particle sizes of between 0.05 and 25µm, rheological additives, foam separators, dyeing agents, stabilizers and/or preservatives.

The water soluble coatings according to the invention proved to be especially suitable for photosensitive layers on the basis of free radical polymerization as a result of their good adhesion and high oxygen impermeability. Preferably aqueous solutions of the water soluble coatings are applied to the photosensitive layers.

The photosensitive layers consist of photoinitiators which absorb within the range of from 300 to 800 nm, free radical polymerizable components, as well as optional alkali soluble binders and additives.

Preferably the basic bodies and/or derivatives of acetophenone, benzophenone, (trichloromethyl)-1,3,5-triazine, benzoin, benzoin ethers, benzoin ketones, xanthone, thioxanthone, acridine, hexarylbisimidazole or dyes are suitable as photoinitiators for photosensitive compositions prepared according to the invention.

The free radical polymerizable component of the compound according to the invention, is an acrylic or methacrylic acid derivative having one or more unsaturated groups, preferably esters of the acrylic or methacrylic acid in the form of monomers, oligomers or prepolymers. It can be present as a solid or as a liquid; solid and viscous forms are preferred. Compounds suitable as monomers include e.g. trimethylol propane triacrylate and methacrylate, pentaerythrit triacrylate and methacrylate, dipentaerythrit monohydroxy pentaacrylate and methacrylate, dipentaerythrite hexaacrylate and methacrylate, pentaerythrit tetraacrylate and methacrylate, ditrimethylol propan tetraacrylate and methacrylate, diethylene glycol diacrylate and methacrylate, triethylene glycol diacrylate and methacrylate or tetraethylene glycol diacrylate and methacrylate. Suitable oligomers and/or prepolymers are urethane acrylates and methacrylates, epoxy acrylates and methacrylates, polyester acrylates and methacrylates, polyether acrylate and methacrylate or unsaturated polyester resins.

The photoinitiators and free radical polymerizable components may be prepared in ways known to one of ordinary skill in the art. Combinations of various photoinitiators and different free radical polymerizable components are advantageous. The weight percentage of the photo initiators is preferably 0.5 to 20 wt.% and that of the free radical polymerizable components 5 to 80 wt.% (based on the total solid weight content of the photosensitive compositions).

Furthermore, exposure indicators e.g. belonging to the triaryl methane dyes (such as Victoria China blue BO, Victoria blue R, crystal violet) or azo dyes (such as 4-phenylazo-diphenyl-amine, azobenzene or 4-N,N-dimethylamino-azobenzene) can be added to the photosensitive layers. The exposure indicators are optionally present in the photosensitive mixture in an amount of from 0.02 to 10 wt.%, preferably 0.5 to 6 wt.%. Dyes for increasing the picture contrasts can be added to the photosensitive layers. Dyes which dissolve in the solvent or solvent mixture used for the coating or may be added as pigment in a dispersed form are quite suitable. The suitable contrast dyes include triphenyl methane dyes, rhodamine dyes, anthraquinone pigments and phthalocyanine dyes and/or pigments.

The photosensitive layers can furthermore optionally contain a softener. Useful softeners include dibutylphthalate, triaryl phosphate and dioctyl phthalate. Dioctyl phthalate is especially preferred. The preferred quantities of softener are 0.25 to 2 wt.%.

According to one embodiment of the present invention the photosensitive layer comprises at least one free radical-forming photoinitiator on mixture of photoinitiators and coinitiators that sensitive the mixture for the wavelengths of from 300 to 800 nm, at least one alkali-soluble carboxyl group containing binder, free radically polymerizable components having unsaturated groups, and actionally further additives.

The water soluble coatings according to the invention are preferably suitable for producing lithographic plates. However, they may be used in recording materials for creating images on- suitable carriers and receiving sheets, for creating reliefs that may serve as printing molds and screens and as light hardenable varnishes for surface protection.

To produce planographic printing plates, aluminum (as the substrate) is first roughened by brushing in the dry state, brushing with abrasive suspensions or electrochemically e.g. in a hydrochloric acid electrolyte. The roughened plates, which were optionally anodically oxidized in sulfuric or phosphoric acid, are then subjected to an hydrophilizing after-treatment, preferably in an aqueous solution of polyvinyl phosphoric acid, sodium silicate or phosphoric acid. The details of the above-mentioned substrate pretreatment are well-known to those of ordinary skill in the art.

The dried plates are then coated with the photosensitive layers of organic solvents and/or solvent mixtures such that dry layer weight per area is preferably from 0.3 to 10 g/m², more preferably 0.8 to 3 g/m². Subsequently the coating is carried out with the water soluble coating according to the invention.

The thus produced lithographic plates are exposed in the common way known to the person skilled in the art. The water soluble coating can be removed separately by water and optionally mechanically by brushing prior to the development process. However, there are also uses in which the removal of the water soluble coating is combined with the development step. The developed plates are usually treated with a preservative ("rubber coat"). The preservatives are aqueous solutions of hydrophilic polymers, wetting agents and other additives.

For specific purposes it is furthermore advantageous to increase the mechanical strength of the printing layers by means of a heat treatment or a combined use of heat and UV radiation. For this purpose, prior to this treatment the plate is first treated with a solution that protects the non-image areas such that the heat treatment will cause no ink receptivity in these areas. A suitable solution is described, e.g. in U.S. Patent 4 355 096.

The following examples illustrate the specific aspects of the present invention as applied to water soluble polymers used as coatings on photosensitive substrates.

### Example 1

### Preparation

25 g polyvinyl alcohol (Airvol 203®, available from Airproducts, Allentown, PA; 12% residual acetyl groups) are completely dissolved in 75 ml water at 60°C under stirring. After adding 6.25 g of 37% hydrochloric acid 3.42 g 2-(N-methylamino)-acetaldehyde dimethyl acetal in 25 ml water are added under stirring at 60°C within a period of 1,5 hours. These conditions are maintained for further 4 hours and subsequently a concentrated aqueous solution of 3.36 g of sodium carbonate is added drop-wise for neutralization until a pH value of 7 is obtained. The polymer is distilled off by adding acetone, filtered off and dried for 24 hours at 40°C in the circulating air dryer. By titration with 0.1 N hydrochloric acid an amino equivalent of 0.00047 mol/g is found.

### Example 2

### Preparation

25 g polyvinyl alcohol (Airvol 203®) are completely dissolved in 75 ml water at 60°C under stirring. After adding 4.1 g of 37% hydrochloric acid 1.15 g 4-aminobutyraldehyde dimethyl acetal in 25 ml water are added-under stirring at 60°C within a period of 1.5 hours. These conditions are maintained for further 4 hours and subsequently a concentrated aqueous solution of 2.2 g of sodium carbonate is added drop-wise for neutralization until a pH value of 7 is obtained. The polymer is distilled off by adding acetone, filtered off and dried for 24 hours at 40°C in the circulating air dryer. By titration with 0.1 N hydrochloric acid an amino equivalent of 0.00026 mol/g is found.

### Example 3

### Preparation

25 g polyvinyl alcohol (Airvol 203® 2.6% residual acetyl groups) are completely dissolved in 75 ml water at 60°C under stirring. After adding 6.25 g of 37% hydrochloric acid 3.42 g 2-(N-methylamino)-acetaldehyde dimethyl acetal in 25 ml water are added under stirring at 60°C within a period of 1.5 hours. These conditions are maintained for further 4 hours and subsequently a concentrated aqueous solution of 3.36 g of sodium carbonate is added drop-wise for neutralization until a pH value of 7 is obtained. The polymer is distilled off by adding acetone, filtered off and dried for 24 hours at 40°C in the circulating air dryer. By titration with 0.1 N hydrochloric acid an amino equivalent of 0.00026 mol/g is found.

### Example 4

### Preparation

25 g polyvinyl alcohol (Airvol 203®) are completely dissolved in 45 ml water and 45 ml n-propanol at 60°C under stirring. After adding 2.9 g of 37% hydrochloric acid 2.9 g 4-N,N-dimethylaminobenzaldehyde in 45 ml n-propanol are added under stirring at 60°C within a period of 1.5 hours. These conditions are maintained for further 4 hours and subsequently a concentrated aqueous solution of 3.36 g of sodium carbonate is added drop-wise for neutralization until a pH value of 7 is obtained. The polymer is distilled off by adding acetone, filtered off and dried for 24 hours at 40°C in the circulating air dryer. By titration with 0.1 N hydrochloric acid an amino equivalent of 0.00077 mol/g is found.

### Example 5

A solution for a photosensitive layer is prepared from the following components:

| | |
|---|---|
| 2.1 g | terpolymer prepared by polymerization of 476 parts by weight styrene, 476 parts by weight methyl methacrylate and 106 parts by weight methacrylic acid |
| 5.24 g | 80% methyl ethyl ketone solution of a urethane acrylate prepared by reacting Desmodur N100, (available from Bayer) with hydroxy ethyl acrylate and pantaerythritol triacrylate with an amount of double bonds of 0.5 double bonds/100g at a total reaction of isocyanate groups |
| 1.29 g | dipentaerythritol pentaacrylate |
| 0.6 g | 2,4-trichloromethyl-6[(4-ethoxy ethyleneoxy)naphtyl]1,3,5-triazine |
| 0.16 g | 4,4'-N,N-diethyl-amino-benzophenone |
| 0.2 g | benzophenone |
| 0.19 g | 3-mercapto-1,2,4-triazol |
| 0.12 g | Renol blue B2G-HW, (copper phthalocyanine pigment dispersed in polyvinyl butyral available from Hoechst) |
| 0.1 g | leuco Crystal Violet |

These components are dissolved under stirring in 100 ml of a mixture comprising
35 parts by volume methyl glycol
25 parts by volume methanol
40 parts by volume methyl ethyl ketone.

After filtering the solution, it is applied to an electrochemically roughened and anodized aluminum foil that was subjected to an aftertreatment using an aqueous solution of polyvinyl phosphoric acid by means of common methods and the coating is dried for 5 minutes at 90°C.

The dry weight of the printing layer amounts to approx. 2.2 g/m². Then, an oxygen-impermeable layer of 1.7 g/m² dry layer weight was applied analogously by applying a coating of an aqueous solution of the following composition:
10 g binder of preparation example 1
150 g water
Drying also took place for 5 minutes at 95°C.

In order to assess the adherence, an adhesive tape is pressed onto the water soluble coating. When pulling off this adhesive tape, the coating is not damaged.

The printing layer is exposed under a silver film halftone step wedge having a tonal range of 0.15 to 1.95, wherein the density increments amount to 0.15, to give a negative model using a metal halogenide lamp (MH burner, available from Sack) of 10mJ/cm².

The exposed coating is treated for 30 seconds with a developer solution comprising
3.4 parts by weight Rewopol NLS 28,
   (available from REWO)
1.8 parts by weight 2-phenoxy ethanol
1.1 parts by weight diethanol amine
1.0 parts by weight Texapon 842,
   (available from Henkel)
0.6 parts by weight Nekal BX Paste,
   (available from BASF)
0.2 parts by weight 4-toluene sulfonic acid
91.9 parts by weight water.

Then the developer solution is again rubbed over the surface for another 30 seconds using a tampon and then the entire plate is rinsed with water. After this treatment the exposed portions remain on the plate. For the assessment of its photosensitivity the plate is blackened in a wet state using a printing ink.

The plate's ink receptivity is good and exposed microscopic lines are very well reproduced. The gray wedge is completely covered up to step 4 and partially covered up to step 7.

If between exposure and development the plates are left in the dark at room temperature for 30 minutes, the same grey wedge is obtained.

For the preparation of a lithographic plate a printing layer is applied to the aluminum foil, as explained above; exposed, developed and after rinsing with water the developed plate is wiped and rubbed with an aqueous solution of 0.5% phosphoric acid and 6% gum arabic. The thus prepared plate positioned in a sheet-fed offset printing machine. The ink receptivity of the plate immediately after the beginning of the printing process is good. Under normal printing conditions the plate provides 200,000 copies of good quality. The plate could be used for more prints.

To simulate aging of the plates, they are stored for 10 days at a temperature of 40°C and 80% relative humidity. The thus treated plates are used for printing in a sheet-fed offset printing machine and exhibit no change in their printing behavior in comparison to the plates that were not artificially aged.

### Example 6

The same photosensitive layer as in Example 5 is used.

For preparing the water soluble overcoat, the following mixture is applied:
10 g of the binding agent from Preparation Example 2
150 g water
Drying took place for 5 min at 95°C.

The assessment of the adhesive strength of the water soluble overcoat and the exposure and development of the printing plate is carried out as described in Example 5.

The adhesion of the overcoat is good. The ink receptivity of the plate is good and exposed microscopic lines are very well reproduced. The gray wedge is completely covered up to step 4 and partially covered up to step 7. If between exposure and development the plates are left in the dark at room temperature for 30 minutes, the same gray wedge is obtained. In a printing test, 200,000 copies of good quality are obtained. After this number of copies, the printing plates were not worn and could have been used for further printing.

### Example 7

The same photosensitive layer as in Example 5 is used.

For preparing the overcoat, the following mixture is applied:
10 g of the binding agent from Preparation Example 3
150 g water
Drying took place for 5 min at 95°C.

The assessment of the adhesive strength of the water soluble overcoat and the exposure and development of the printing plate is carried out as described in Example 5.

The adhesion of the overcoat is good. The ink receptivity of the plate is good and exposed microscopic lines are very well reproduced. The gray wedge is completely covered up to step 4 and partially covered up to step 7. If between exposure and development the plates are left in the dark at room temperature for 30 minutes, the same gray wedge is obtained. In a printing test, 200,000 copies of good quality are obtained. After this number of copies, the printing plates were not worn and could have been used for further printing.

### Example 8

The same photosensitive layer as in Example 5 is used.

For preparing the overcoat, the following mixture is applied:
10 g of the binding agent from Preparation Example 4
150 g water
Drying took place for 5 min at 95°C.

The assessment of the adhesive strength of the overcoat and the exposure and development of the printing plate is carried out as described in Example 5.

The adhesion of the overcoat is good. The ink receptivity of the plate is good and exposed microscopic lines are very well reproduced. The gray wedge is completely covered up to step 4 and partially covered up to step 7. If between exposure and development the plates are left in the dark at room temperature for 30 minutes, the same gray wedge is obtained. In a printing test, 200,000 copies of good quality are obtained. After this number of copies, the printing plates were not worn and could have been used for further printing.

### Example 9

The same photosensitive layer as in Example 5 is used.

For preparing the overcoat, the following mixture is applied:

| | |
|---|---|
| 45 g | polyvinylalcohol (Airvol 203®) |
| 5 g | of a copolymer of 94 mol % vinyl alcohol and 5.8 mol % vinyl amine and 0.2 mol % vinylacetate with a molecular weight of 36,000 |
| 500 g | water |

Drying took place for 5 min at 95°C.

The assessment of the adhesive strength of the water soluble overcoat and the exposure and development of the printing plate is carried out as described in Example 5.

The adhesion of the overcoat is good. The ink receptivity of the plate is good and exposed microscopic lines are very well reproduced. The gray wedge is completely covered up to step 4 and partially covered up to step 7. If between exposure and development the plates are left in the dark at room temperature for 30 minutes, the same gray wedge is obtained. In a printing test, 200,000 copies of good quality are obtained. After this number of copies, the printing plates were not worn and could have been used for further printing.

### Example 10

The same photosensitive layer as in Example 5 is used.

For preparing the overcoat, the following mixture is applied:

| | |
|---|---|
| 42 g | polyvinylalcohol (Airvol 203®) |
| 5 g | of a copolymer of 94 mol % vinyl alcohol and 5.8 mol % vinyl amine and 0.2 mol % vinylacetate with a molecular weight of 36,000 |
| 0.01 g | Marlophen 1028N (alkylphenolpolyethylenglycolether, available from Hüls) |
| 3 g | polysilicic acid with an average particle size of 5.7 µm and a BET surface of 320 m²/g |
| 500 g | water |

Drying took place for 5 min at 95°C.

The assessment of the adhesive strength of the overcoat and the exposure and development of the printing plate is carried out as described in Example 5.

The adhesion of the overcoat is good. The ink receptivity of the plate is good and exposed microscopic lines are very well reproduced. The gray wedge is completely covered up to step 4 and partially covered up to step 7. If between exposure and development the plates are left in the dark at room temperature for 30 minutes, the same gray wedge is obtained. In a printing test, 200,000 copies of good quality are obtained. After this number of copies, the printing plates were not worn and could have been used for further printing.

### Example 11

### Comparative

The same photosensitive layer as in Example 5 is used.

For preparing the overcoat, the following mixture is applied:

| | |
|---|---|
| 50 g | polyvinylalcohol (Airvol 203®) |
| 500 g | water |

Drying took place for 5 min at 95°C.

The assessment of the adhesive strength of the water soluble overcoat and the exposure and development of the printing plate is carried out as described in Example 5.

The adhesion of the overcoat is very poor. The adhesive tape removes almost the entire areas to which the tape adhered from the photosensitive layer. At the cutting edges the overcoat peels off.

The ink receptivity of the plate is good and exposed microscopic lines are very well reproduced. The gray wedge is completely covered up to step 4 and partially covered up to step 7. If between exposure and development the plates are left in the dark at room temperature for 30 minutes, the same gray wedge is obtained. In a printing test, 200,000 copies of good quality are obtained. After this number of copies, the printing plates were not worn and could have been used for further printing.

### Example 12

### Comparative

The same photosensitive layer as in Example 5 is used.

For preparing the overcoat, the following mixture is applied:

| | |
|---|---|
| 45 g | polyvinylalcohol (Airvol 203®) |
| 5 g | Polymin P (polyethylene imine, available from BASF) |
| 500 g | water |

Drying took place for 5 min at 95°C.

The assessment of the adhesive strength of the overcoat and the exposure and development of the printing plate is carried out as described in Example 5.

The adhesion of the overcoat is good. The ink receptivity of the plate is good and exposed microscopic lines are very well reproduced. The plates which were subjected to simulated ageing at a temperature of 40°C and 80% relative humidity for 10 days exhibited blotchy imperfections of the ink receptivity which did not disappear even after a larger number of copies had been printed.

### Example 13

### Comparative

The same photosensitive layer as in Example 5 is used.

For preparing the overcoat, the following mixture is applied:

| | |
|---|---|
| 50 g | polyvinyl alcohol (Airvol 203®) |
| 450 g | water |
| 50 g | ethanol |

Drying takes place for 5 min at 95°C.

The assessment of the adhesive strength of the overcoat and the exposure and development of the printing plate is carried out as described in Example 5.

The adhesion of the overcoat is poor. Large areas are removed together with the adhesive tape.

During mechanical coating by means of dipping rolls yellow components of the photosensitive layer accumulate in the dipping bath of the overcoat solution.

The ink receptivity of the plate is good, but exposed microscopic lines are not completely reproduced.

### Example 14

### Comparative

The same photosensitive layer as in Example 5 is used.

For preparing the overcoat, the following mixture is applied:

| | |
|---|---|
| 40 g | polyvinyl alcohol (Airvol 203®) |
| 30 g | of a 30% dispersion of a terpolymer obtained from 66 wt.% methyl methacrylate, 29 wt.% ethyl acrylate and 5 wt.% methacrylic acid in a mixture of 90 wt.% water and 10 wt.% ethyleneglycol monomethylether |
| 480 g | water |

Drying takes place for 5 min at 95°C.

The assessment of the adhesive strength of the water soluble overcoat and the exposure and development of the printing plate is carried out as described in Example 5.

The adhesion of the overcoat is very poor. The adhesive tape removes almost the entire areas to which the tape adhered from the photosensitive layer. At the cutting edges the overcoat peels off.

The ink receptivity is good and exposed microscopic lines are very well reproduced. The gray wedge is completely covered up to step 3 and partially covered up to step 6. If, however, between exposure and development the plate is left in the dark at room temperature for 30 minutes no image is obtained after development. This fact points to a low degree of oxygen impermeability of the overcoat. Furthermore, plates that were subjected to simulated aging at a temperature of 40°C and 80% relative humidity for 10 days showed an extension of the grey wedge by 4 steps. Also in the case of the artificially aged plates, the image-free areas were not completely clean but showed a tendency towards ink receptivity.

### Example 15

### Comparative

The same photosensitive layer as in Example 5 is used.

For preparing the water soluble overcoat, the following mixture is applied:

| | |
|---|---|
| 48.5 g | polyvinyl alcohol (Airvol 203®) |
| 1.5 g | glycin |
| 500 g | water |

Drying takes place for 5 min at 95°C.

The assessment of the adhesive strength of the overcoat and the exposure and development of the printing plate is carried out as described in Example 5.

The adhesion of the overcoat is very poor. The adhesive tape removes almost the entire areas to which the tape adhered. At the cutting edges the overcoat peels off.

The ink receptivity is good and exposed microscopic lines are very well reproduced. The gray wedge is completely covered up to step 4 and partially covered up to step 7.

The present invention has been described in detail, including the preferred embodiments thereof. However, it will be appreciated that those skilled in the art, upon consideration of the present disclosure, may make modifications and/or improvements to this invention that fall within the scope and spirit of the inventiion as set forth in the following claims.

## Claims

1. Light-sensitive system comprising
a photosensitive layer consisting of photoinitiators which absorb within the range of from 300 to 800 mm, free radical polymerizable components, and optionally alkali soluble binders and/or additives, and a water-soluble overcoat, wherein the overcoat comprises a polymer consisting of the following units: 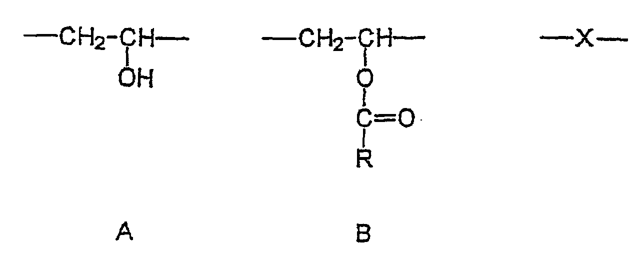 wherein R is an alkyl group having 1 to 8 carbon atoms and X comprises an amino group connected to the polymer chain either directly or via a spacer.

2. The light-sensitive system according to claim 1, wherein the basic, nitrogen-containing binder unit X is at least one of structures: 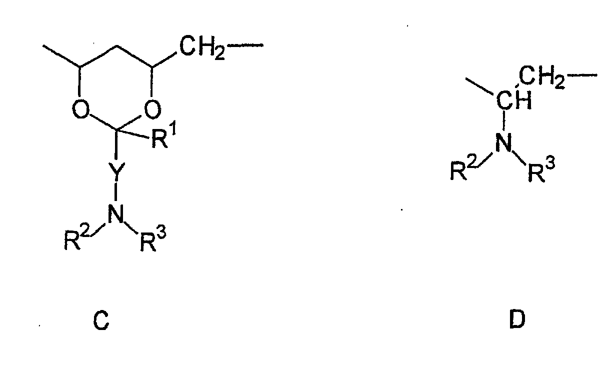 wherein R¹, R² and R³ are independently selected from hydrogen, alkyl, aralkyl or aryl and Y is an aliphatic, aromatic or araliphatic spacer group.

3. The light-sensitive system according to claim 1 or 2, wherein the polymer consists of vinyl alcohol, vinyl acetate and vinyl amine units.

4. The light-sensitive system of any of claims 1 or 2, wherein the polymer consists of vinyl alcohol and vinyl acetate units as well as unit C, wherein R¹ and R² are hydrogen, R³ is a methyl and Y is a methylene group.

5. The light-sensitive system of any of claims 1 or 2, wherein the polymer consists of vinyl alcohol and vinyl acetate units as well as unit C, wherein R¹, R² and R³ are hydrogen and Y is a -(CH₂)₄- group.

6. The light-sensitive system of any of claims 1 or 2, wherein the polymer consists of vinyl alcohol and vinyl acetate units as well as unit C, wherein R¹ is hydrogen, R² and R³ are a methyl and Y is a 1,4-phenylene group.

7. The light-sensitive system of any of claims 1 to 5, wherein the polymer consists of 10 to 98 wt.% unit A, 0.1 to 30 wt.% unit B and 0.1 to 60 wt.% unit X.

8. The light-sensitive system of any of claims 1 to 7 wherein the overcoat additionally comprises at least one other polymer consisting of vinyl alcohol and vinyl acetate groups and/or at least one common additive.

9. The light-sensitive system of claim 8, wherein the additive is selected from a wetting agent, a solid having particle sizes of between 0.05 and 25 µm, rheological additives, foam separators, dyeing agents, stabilizers and/or preservatives.

10. The light-sensitive system of any of claims 1 to 9, wherein the photosensitive layer comprises at least one free radical-forming photoinitiator or mixture of photoinitiators and coinitiators that sensitize the mixture for the wavelengths of from 300 to 800 nm, at least one alkali-soluble carboxyl group containing binder, free radically polymerizable components having unsaturated groups, and optionally further additives.

11. The light-sensitive system of any of claims 1 to 10, wherein the substrate is aluminum.

## Patentansprüche

1. Lichtempfindliches System, umfassend eine lichtempfindliche Schicht, die aus Photoinitiatoren, die im Bereich von 300 bis 800 nm absorbieren, radikalisch polymerisierbaren Komponenten und gegebenenfalls alkalilöslichen Bindemitteln und/oder Additiven besteht, und eine wasserlösliche Deckschicht, wobei die Deckschicht ein Polymer, bestehend aus folgenden Einheiten, umfaßt: 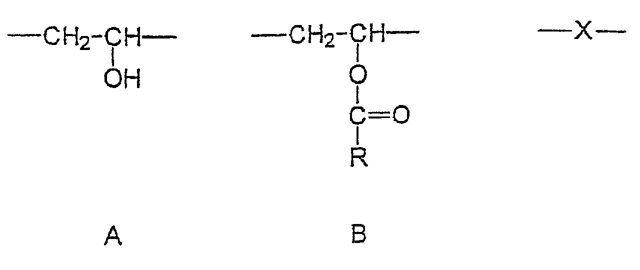 wobei R einen Alkylrest mit 1 bis 8 Kohlenstoffatomen darstellt und X eine Aminogruppe umfaßt, die entweder direkt oder über einen Spacer mit der Polymerkette verknüpft ist.

2. Lichtempfindliches System gemäß Anspruch 1, wobei die basische, stickstoffhaltige Bindemitteleinheit X wenigstens eine der folgenden Strukturen darstellt: 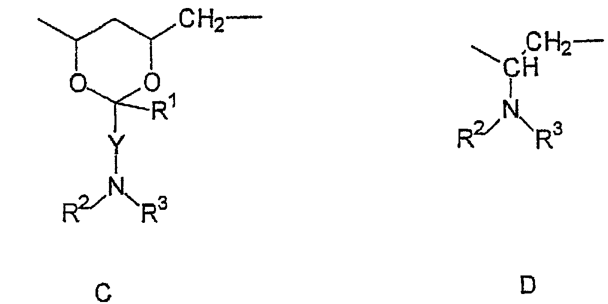 in deren R¹, R² und R³ unabhängig aus einem Wasserstoffatom, einem Alkyl-, Aralkyloder Arylrest ausgewählt sind und Y eine aliphatische, aromatische oder araliphatische Spacergruppierung darstellt.

3. Lichtempfindliches System gemäß Anspruch 1 oder 2, wobei das Polymer aus Vinylalkohol-, Vinylacetat- und Vinylamineinheiten besteht.

4. Lichtempfindliches System gemäß einem der Ansprüche 1 oder 2, wobei das Polymer aus Vinylalkohol- und Vinylacetateinheiten sowie Einheit C besteht, in der R¹ und R² ein Wasserstoffatom darstellen, R³ eine Methylgruppe darstellt und Y eine Methylengruppe darstellt.

5. Lichtempfindliches System gemäß einem der Ansprüche 1 oder 2, wobei das Polymer aus Vinylalkohol- und Vinylacetateinheiten sowie Einheit C besteht, in der R¹, R² und R³ ein Wasserstoffatom darstellen und Y eine -(CH₂)₄-Gruppe darstellt.

6. Lichtempfindliches System gemäß einem der Ansprüche 1 oder 2, wobei das Polymer aus Vinylalkohol- und Vinylacetateinheiten sowie Einheit C besteht, in der R¹ ein Wasserstoffatom darstellt, R² und R³ eine Methylgruppe darstellen und Y eine 1,4-Phenylengruppe darstellt.

7. Lichtempfindliches System gemäß einem der Ansprüche 1 bis 5, wobei das Polymer aus 10 bis 98 Gew.-% Einheit A, 0,1 bis 30 Gew.-% Einheit B und 0,1 bis 60 Gew.-% Einheit X besteht.

8. Lichtempfindliches System gemäß einem der Ansprüche 1 bis 7, wobei die Deckschicht ferner mindestens ein weiteres aus Vinylalkohol- und Vinylacetatgruppen aufgebautes Polymer und/oder mindestens ein übliches Additiv umfaßt.

9. Lichtempfindliches System gemäß Anspruch 8, wobei das Additiv aus einem Netzmittel, einem Feststoff mit Teilchengrößen zwischen 0,05 und 25 µm, rheologischen Additiven, Entschäumern, Anfärbemitteln, Stabilisatoren und/oder Konservierungsmitteln gewählt ist.

10. Lichtempfindliches System gemäß einem der Ansprüche 1 bis 9, wobei die lichtempfindliche Schicht mindestens einen radikalbildenden Photoinitiator oder ein Gemisch aus Photoinitiatoren und Coinitiatoren, die das Gemisch für den Wellenlängenbereich von 300 bis 800 nm sensibilisieren, wenigstens ein alkalilösliches, carboxylgruppenhaltiges Bindemittel, radikalisch polymerisierbare Bestandteile mit ungesättigten Gruppen und gegebenenfalls weitere Zusatzstoffe umfaßt.

11. Lichtempfindliches System nach einem der Ansprüche 1 bis 10, wobei das Substrat Aluminium ist.

## Revendications

1. Système sensible à la lumière, comprenant une couche photosensible constituée de photo-initiateurs qui absorbent dans le domaine de 300 à 800 nm, de constituants radicalaires polymérisables et, éventuellement, de liants et/ou d'additifs solubles dans les bases, et une couche de finition soluble dans l'eau, dans lequel la couche de finition comprend un polymère constitué des motifs suivants: 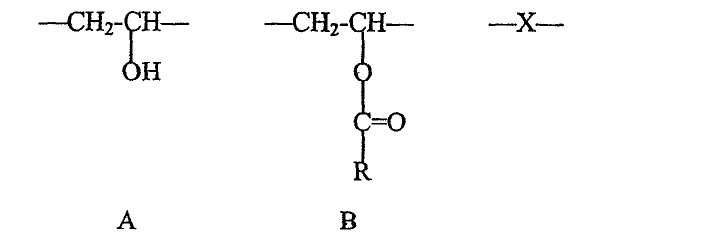 dans lesquels R est un groupe alkyle comportant 1 à 8 atomes de carbone et X comprend un groupe amino relié à la chaîne du polymère soit directement, soit par un groupe espaceur.

2. Système sensible à la lumière selon la revendication 1, dans lequel le motif liant azoté basique X a au moins l'une des structures: 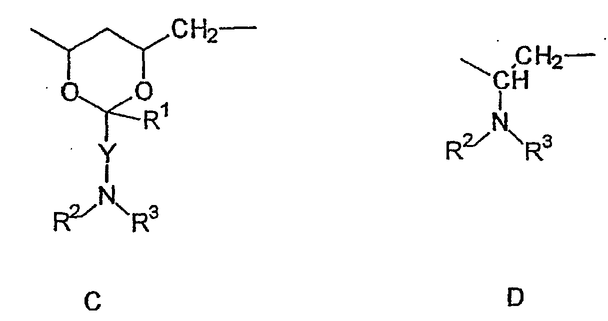 dans lesquelles R¹, R² et R³ sont choisis indépendamment parmi les atomes d'hydrogène et les groupes alkyle, aralkyle ou aryle, et Y est un groupe espaceur aliphatique, aromatique ou araliphatique.

3. Système sensible à la lumière selon la revendication 1 ou 2, dans lequel le polymère se compose de motifs alcool vinylique, acétate de vinyle et vinylamine.

4. Système sensible à la lumière selon la revendication 1 ou 2, dans lequel le polymère se compose de motifs alcool vinylique et acétate de vinyle ainsi que du motif C, dans lequel R¹ et R² sont des atomes d'hydrogène, R³ est un groupe méthyle et Y est un groupe méthylène.

5. Système sensible à la lumière selon l'une quelconque des revendications 1 ou 2, dans lequel le polymère se compose de motifs alcool vinylique et acétate de vinyle ainsi que du motif C, dans lequel R¹, R² et R³ sont des atomes d'hydrogène et Y est un groupe -(CH₂)₄-.

6. Système sensible à la lumière selon la revendication 1 ou 2, dans lequel le polymère se compose de motifs alcool vinylique et acétate de vinyle ainsi que du motif C, dans lequel R¹ est un atome d'hydrogène, R² et R³ sont des groupes méthyle et Y est un groupe 1,4-phénylène.

7. Système sensible à la lumière selon l'une quelconque des revendications 1 à 5, dans lequel le polymère se compose de 10 à 98% en poids de motifs A, de 0,1 à 30% en poids de motifs B et de 0,1 à 60% en poids de motifs X.

8. Système sensible à la lumière selon l'une quelconque des revendications 1 à 7, dans lequel la couche de finition comprend également au moins un autre polymère constitué de groupes alcool vinylique et acétate de vinyle et/ou au moins un additif commun.

9. Système sensible à la lumière selon la revendication 8, dans lequel l'additif se compose d'un agent mouillant, d'un solide ayant une granulométrie comprise entre 0,05 et 25 µm, d'additifs rhéologiques, de séparateurs de mousse, d'agents teintants, de stabilisants et/ou de conservateurs.

10. Système sensible à la lumière selon l'une quelconque des revendications 1 à 9, dans lequel la couche photosensible comprend au moins un photo-initiateur radicalaire ou un mélange de photo-initiateurs et de co-initiateurs qui sensibilisent le mélange pour les longueurs d'onde de 300 à 800 nm, au moins un liant contenant un groupe carboxyle soluble dans les bases, des constituants radicalaires polymérisables comportant des groupes insaturés et, éventuellement, d'autres additifs.

11. Système sensible à la lumière selon l'une quelconque des revendications 1 à 10, dans lequel le substrat est l'aluminium.
